Europäisches Patentamt

European Patent Office

Office européen des brevets

(19)

(11) **EP 0 985 977 A1**

(12) **EUROPEAN PATENT APPLICATION**

(43) Date of publication:
**15.03.2000 Bulletin 2000/11**

(51) Int Cl.⁷: **G03F 7/20**

(21) Application number: **99306919.4**

(22) Date of filing: **31.08.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventor: **Eichner, Ludwig**<br>**Warren, New Jersey 07060 (US)** |
| (30) Priority: **11.09.1998 US 151628** | (74) Representative:<br>**Johnston, Kenneth Graham et al**<br>**Lucent Technologies (UK) Ltd,**<br>**5 Mornington Road**<br>**Woodford Green Essex, IG8 OTU (GB)** |
| (71) Applicant: **LUCENT TECHNOLOGIES INC.**<br>**Murray Hill, New Jersey 07974-0636 (US)** | |

(54) **Integrated circuit device fabrication utilizing latent imagery**

(57)     A lithographic process for device fabrication in which first order diffraction information of latent images in an energy sensitive material is used to control process parameters is disclosed. A latent image is introduced into a layer of an energy sensitive resist material formed on a substrate. A beam of radiation having a wavelength of about 632.8 nm to about 325 nm is directed onto the latent image at a glancing angle that is selected to provide first order diffraction information in the reflected radiation that is collected by an objective. The first order diffraction information from the latent image is correlated with at least one parameter of the lithographic process such as, for example, focus, lamp intensity, exposure dose, exposure time, or post exposure bake. The correlation is obtained by analyzing the effect of a selected parameter on the intensity of the first order diffraction information and selecting a value for the parameter that corresponds to an acceptable intensity.

EP 0 985 977 A1

**Description**

**BACKGROUND OF THE INVENTION**

**Technical Field**

The present invention relates generally to the production of latent photographic images in resist materials and the subsequent use of those latent images in processes for integrated circuit fabrication.

**Art Background**

The advent of semiconductor devices and structures with submicron device rules has presented a need for more rigorous process control. In lithographic processes used in device fabrication (i.e. processes in which a desired pattern is introduced into an energy sensitive resist material via a patternwise exposure to energy, developed, and transformed into an underlying substrate) the process is controlled by generating a sample of the pattern, inspecting the pattern that is actually formed in the energy sensitive resist material, comparing the actual pattern, and making the necessary adjustments to the process to make the actual pattern correspond more closely to the desired pattern. The problem associated with this technique is determining the parameter that must be adjusted so that the actual pattern corresponds acceptably to the desired pattern. The information obtained by inspecting the developed resist features does not provide a basis for real-time control of the lithographic process.

In lithographic processes, a discrepancy between the actual pattern and the desired pattern can result from a problem with the mask (i.e., the patterned reticule used to patternwise expose the energy sensitive resist material) or a problem with other materials and equipment used in the lithographic process. The act of inspecting the developed resist features does not pinpoint the source of the error if a greater-than-acceptable discrepancy is discovered between the desired pattern and the actual pattern.

In response to this problem, techniques have been developed for inspecting the latent features introduced into an energy sensitive material before that image is developed. One such technique is known as latent image metrology. By detecting a discrepancy between the latent image of the actual pattern and the desired pattern, one can more quickly pinpoint the source of that discrepancy. One such technique is described in Adams, T. E., "Applications of Latent Image Metrology in Microlithography", Proc. SPIE 1464, p. 294 (1991).

Adams describes a technique in which a latent image is introduced into an energy sensitive resist material and a portion of that latent image is subjected to white light which is scattered by the energy sensitive resist material. The latent image in the resist material affects the light in a way that provides information about the latent image. The scattered light is then detected. The amplitude of the detected signal is then used to evaluate the lithographic apparatus design, or adjust the exposure dose or focus used to introduce the image into the resist material. This evaluation is accomplished by analyzing the scattering amplitude as a function of the various image printing parameters.

This technique for evaluating a latent feature is limited because the classical diffraction limit for light is typically greater than $0.5\,\mu m$. Therefore, images of feature sizes that are less than $0.5\,\mu m$ in size are difficult to detect accurately with this technique. Furthermore, to use this technique, a periodic array of features must be printed in the resist material. In a blanket exposure, however, the entire resist layer is exposed without features. This technique cannot be used to obtain meaningful information concerning a blanket exposure because there is an insufficient difference in scattering amplitude in a blanket exposure without features. Subtle differences in the blanket exposure caused by an uneven exposure or a less than uniform resist material will not be detected if a blanket exposure is examined using this technique.

**Summary of the Invention**

The present invention is directed to a lithographic process for integrated circuit device fabrication in which an image of a desired pattern is introduced into an energy sensitive material applied onto a substrate. The image is introduced into the energy sensitive material via a patternwise exposure to radiation. The image is then developed and transferred into the underlying substrate. The pattern is incorporated into a feature or features of the resulting device.

In the process of the present invention, a latent image of an inspection pattern is inspected using a diffractive intensity quality technique. The results of that inspection are used to control the lithographic process. The inspection pattern is any pattern that will produce a diffraction pattern when the latent image of the pattern is illuminated by incident radiation of a desired wavelength. It is therefore advantageous if the inspection pattern is a series of lines and spaces or other such alternating pattern because the images of such patterns (the image being alternating regions of unexposed and exposed regions in the energy sensitive resist material) provide desirable diffraction patterns. One example of a suitable pattern is a first series of horizontal lines and spaces and a second series of vertical lines and spaces in which the period of each series is the same (a period being the center-line to center-line distance between two adjacent lines or spaces). Another example of a suitable pattern is a first series of horizontal lines and spaces and a second series of vertical lines and spaces in which the period of the first series is different from the period of the second series. In a third example, the pattern is a series of horizontal lines and spaces combined with a series of vertical lines and spaces (i.e. a series of windows) that produce dispersion in both the horizontal and vertical directions.

The latent image introduced into the energy sensitive material is then inspected by illumination with a probe beam which impinges upon the latent image in the resist at an angle (referred to as the glancing angle herein) that is selected to provide reflected radiation such that the diffraction intensities in the detected radiation are first order or higher and the zero order diffraction intensity is not detected. This is accomplished by providing a detector with an objective that is sized and positioned to collect the desired diffraction intensities. Both the glancing angle and the numerical aperture are selected to accomplish this objective. It is advantageous if the glancing angle is selected so that, for a given numerical aperture and focal distance, that glancing angle can be used to collect first order and higher diffraction intensity from a broad range of periodic gratings (i.e. gratings with periods ranging from 0.18 $\mu$m to 0.3 $\mu$m.

In order to detect the first order and higher intensity, the reflected radiation must be collected by the objective. The radiation reflected by the grating has a certain angular dispersion. For a given grating, the angular dispersion is a function of the wavelength of the incident radiation. Thus, for a given periodic grating, the wavelength of the incident radiation is selected to control the angular dispersion of the reflected radiation so that the reflected radiation is collected by the objective.

In one embodiment of the present invention, the glancing angle of the probe beam is about five degrees to about ten degrees from the surface of the resist material which is the equivalent of about thirty degrees to about eighty-five degrees from a line normal to the surface of the energy sensitive resist material. It is advantageous if the glancing angle is about five degrees to about ten degrees from the surface of the resist material. If the glancing angle is within this range then the desired intensities (i.e. first order and higher) will be collected and the zero order radiation will not. Such a result is not achieved when the radiation is incident on the surface at an angle approximating ninety degrees. At such an angle, the zero order diffraction from the substrate is not significantly separate from the higher order diffraction from the substrate.

The selected glancing angle is also a function of the wavelength of the radiation from the probe. For example, to determine the glancing angle needed to obtain nth order diffraction intensities, the glancing angle is determined by

$$\theta = \lambda m/d$$

wherein m is the order (m=1 for 1st order), $\lambda$ is the wavelength of the incident radiation (i.e. the probe beam) and d is the period of the grating. If first order diffraction intensities are the only diffraction intensities of interest, then the glancing angle is simply the wavelength of the incident radiation divided by the period of the pattern.

The process of the present invention is used to control the operating parameters of a variety of lithographic exposure tools. In one embodiment, the lithographic parameters of a process utilizing a deep ultra violet exposure tool are controlled using the process of the present invention. In an alternative embodiment, the lithographic parameters of a process utilizing a projection electron exposure tool are controlled using the process of the present invention. One example of a projection electron tool is the SCALPEL (i.e. scattering with angular limitation projection electron beam lithography ) tool.

In the process of the present invention, it is advantageous if the latent image is inspected before the latent image is either subjected to a post-exposure bake or developed into a pattern. One skilled in the art is aware of the use of a post-exposure bake as a mechanism to advance the chemical reactions that are initiated by exposing the energy sensitive resist material to radiation. The post-exposure bake and development steps introduce additional variables in the lithographic process. Since the present invention is directed to a process for controlling lithographic process parameters by inspecting a latent image, an association between the inspection and a process parameter must be made. If the inspection is made after post-exposure bake or development, such an association is more difficult unless the effects of the post exposure bake or the development are well understood.

By inspecting the latent image in the effects of lens aberrations on the image are controlled. Lens aberrations include lens astigmatism, field curvature, spherical aberrations and coma. Other lithographic parameters that are controlled using the process of the present invention include machine focus, dose control, local leveling, field uniformity, depth of focus, exposure column tilt, exposure tool resolution and focus offset.

The process of the present invention is also used to evaluate the performance of a lithographic tool or to compare the performance of multiple lithographic tools. This is accomplished by simply inspecting the latent images that are created by the lithographic tool or tools. From the first order diffraction information that is obtained as a result of the inspections, the lithographic tool that provided the image associated with the most desirable diffraction information (e.g. maximum or near-maximum intensity) is selected.

Similarly, the process of the present invention is used to evaluate wafer stages and wafer chucks. This is accomplished by simply inspecting the latent images that are created using the various wafer stages or wafer chucks. From the first order diffraction information that is obtained as a result of the inspections, the wafer stage or wafer chuck that provided the image associated with the most desirable diffraction information (e.g. maximum or near-maximum intensity) is selected.

The process of the present invention is also used to evaluate the effect of the environment on the lithographic process. As used herein, the environment of the lithographic process is the environmental conditions under which the latent image is introduced into the energy sensitive resist material. Examples of environmental conditions include the atmosphere (e.g., either vacuum or gaseous and, if gaseous, the composition of the gas), the temperature, and the pressure. This is accomplished by simply inspecting the latent images that are created using the various environmental conditions. From the first order diffraction information that is obtained as a result of the inspections, the environmental conditions that provide the image associated with the most desirable diffraction information (e.g. maximum or near-maximum intensity) are selected.

**BRIEF DESCRIPTION OF THE DRAWINGS**

FIG. 1 is a schematic illustration of a lithographic process

FIG. 2 illustrates the prior art method of normal incident latent image analysis.

FIG. 3 illustrates the present process for latent image analysis in which the probe beam is incident on the energy-sensitive resist material at the prescribed glancing angle.

FIG. 4A-4I are graphs of first order diffraction intensity as a function of focus variations for a latent image of 0.25 $\mu$m lines and spaces in nine different locations in a layer of energy sensitive resist material.

FIG. 5 is a graph of first order diffraction intensity as a function of focus and dose variations for a latent image of 0.18 $\mu$m lines and spaces in 41 dose fields by 41 focus fields in a layer of energy sensitive resist material.

FIG. 6 illustrates the relationship between the measured intensity of a series of latent images and the focus used to create those images, wherein the intensity of the latent images is measured using the process of the present invention.

**DETAILED DESCRIPTION**

The present invention is directed to a process for controlling at least one aspect of a lithographic process by inspecting energy sensitive resist materials that have been exposed to patterned radiation. In the process of the present invention, an energy sensitive resist material is exposed to radiation to introduce the latent image of an inspection pattern therein. The exposed energy-sensitive material is then inspected using a technique designed to selectively detect first order and, optionally, higher order diffraction information from a portion or portions of the energy-sensitive material with the latent image therein. The first order and higher order diffraction information are detected selectively because the zero order diffraction information is not detected. Specifically, due to the glancing angle of the incident radiation, the zero order diffraction information has an angle of escape from the substrate that is significantly different than the angle of escape of the first and higher order diffraction information. The differences in angles of escape between zero order diffraction information and first and higher order diffraction information are significant. Because of these differences, the first and higher order diffraction information is detectable selectively. Selective detection is obtained by selecting an objective with a focal length and a numerical aperture that collects the desired diffraction information without collecting the zero order diffraction information. The first order diffraction information is used to either control the lithographic process or to characterize the mask (also referred to as a reticle) of the lithographic exposure tool (e.g. a deep UV lithography tool, a SCALPEL tool) used in the lithographic process. The lithographic parameters controlled by the present process include lamp intensity, focus, exposure dose, source coherence, and bake temperature.

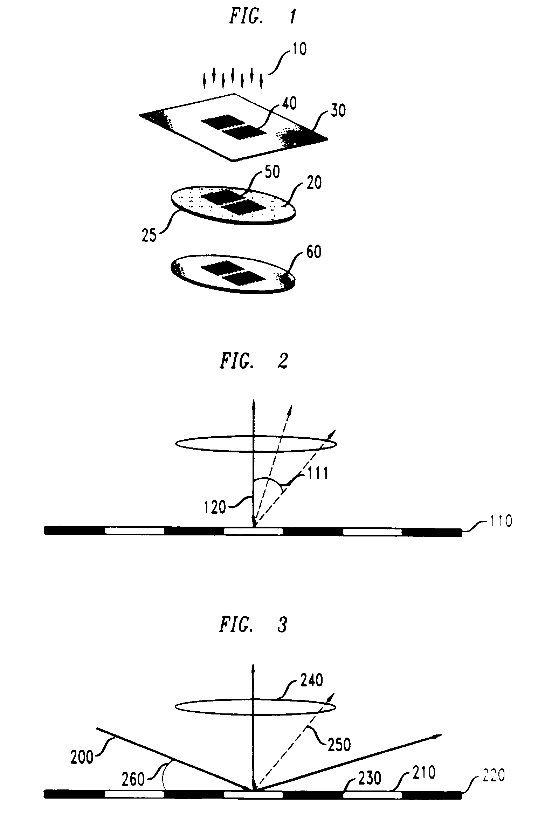

A typical lithographic process is illustrated schematically in FIG. 1. Exposing radiation 10 is directed toward a layer of energy sensitive resist material 20 formed on a substrate 25. The energy sensitive resist material 20 is then patternwise exposed to radiation. One way to effect the desired patternwise exposure is to interpose a mask 30 between the source of exposing radiation 10 and the energy sensitive resist material 20. The lines 40 in the mask 30 are apertures through which the radiation passes to the energy sensitive resist material 20. Each of the lines 50 in the energy sensitive resist material is a latent feature. The radiation causes a change in the exposed energy sensitive resist material. This change is either a chemical change and/or a structural change in the resist material composition. These changes typically cause the refractive index of the material to change. The chemical difference between the exposed energy sensitive resist material and the unexposed energy sensitive resist material is exploited to develop the pattern 60 in the energy sensitive material.

The present process is used in conjunction with lithographic processes for device fabrication. The materials and conditions used to introduce the latent image of a pattern in an energy sensitive material are those that are typically used in processes for device fabrication. One skilled in the art is capable of selecting the appropriate materials and conditions for a particular application. Since the process provides particular advantages when the design rules for the fabricated devices are 0.5 μm or less, the exposing radiation will typically be ultraviolet radiation, x-ray radiation, or electron beam radiation. The energy sensitive resist materials selected are those that are suitably sensitive to radiation in the ultraviolet or x-ray range, or to electron beam radiation.

After the image is introduced into the energy sensitive resist material, a spatially resolved image of the latent feature or features in the energy sensitive material is obtained. This is accomplished by selecting a glancing angle that is suitable for directing the first and higher order diffraction from the image into the objective and directing zero order diffraction from the image away from the objective. Based upon the wavelength of the incident radiation, the order of the diffraction, and the period of the inspection pattern, the angular escape limits of the diffraction of a particular order are determined for a particular glancing angle. The glancing angle that provides the desired order of diffraction to the objective (based on the numerical aperture and the focal length of that objective) is then selected. At the selected glancing angle, the zero order diffraction from the image is not directed into the objective. The image is then illuminated using a beam of radiation that impinges upon the resist at the prescribed glancing angle. For the purposes of this discussion, a glancing angle is the angle at which the probe beam impinges upon the substrate relative to the substrate surface. The radiation reflected from the surface is then collected by an objective. The objective is coupled to a video camera or like device, which is used to capture data which is then used to ascertain and evaluate the latent image in the energy sensitive resist material.

In one embodiment of the present invention, a helium neon laser illumination probe (λ = 632 nm) is used to inspect gratings with periods in the range of about 0.18 μm to about 0.6 μm. In order to inspect gratings with periods in the rage of about 0.1 μm to about 0.25 μm, a helium cadmium illumination probe (λ of about 320 nm to about 440 nm) is suitable. Consequently, the process of the present invention is sufficiently robust so that those patterns having a wide range of periods are inspected using a single apparatus.

The glancing angle and the numerical aperture are selected so that only first order and higher diffraction is collected by the objective. One skilled in the art will appreciate that first order and higher diffraction is not a reflection or a refraction intensity. Diffraction patterns or an intensity distribution due to a sinusoidal phase grating is defined by the following relationship:

$$I(x_0, y_0) = \left[\frac{l^2}{\lambda z}\right]^2 \sum_{q=-\infty}^{\infty} J_{q^2}\left(\frac{m}{2}\right) \sin c^2 \left[\frac{1}{\lambda z}(x_0 - q f_0 \lambda z)\right] \sin c^2 \left(\frac{l y_0}{\lambda z}\right). \quad (1)$$

As defined by the above equation, the displacement or angular dispersion of the qth order from the zero order is $q f_0 \lambda z$.

One skilled in the art is aware that first order and higher order diffraction patterns are present in radiation that is reflected from periodic structures such as gratings. In the process of the present invention, zero order diffraction is not collected by the objective. This is in contrast to the techniques in which the latent image is inspected using radiation that impinges on the energy sensitive resist material at an angle that is normal to the surface of the resist material. As illustrated in FIG. 2, first order and higher diffraction that is collectable when the radiation impinges normal to the surface is limited by the period of features (i.e. a series of lines and spaces refers to gratings). Specifically, the maximum first order diffraction is reflected from the surface 100 of the energy sensitive material 110 at an angle θ (111) from the probe beam 120 which is normal to the surface. Because of the relationship

$$\theta = \lambda m/d$$

wherein λ is the wavelength of the incident radiation, m is the order of dispersion and d is the period of the grating under inspection, the angle of dispersion gets larger as the period gets smaller. Therefore, as the period gets smaller, the numerical aperture required to capture the first order and higher diffraction gets larger. There is a physical and practical limit on the size of numerical apertures. For example, when a dark field 0.9 NA objective is used, the minimum grating period for which latent grating dispersion intensity information is resolvable is about 350 nm.

Since the process of the present invention is used to inspect latent images in energy sensitive material, the wavelength of the incident radiation is selected to be outside the range of wavelengths that induce a chemical change in the energy sensitive resist material. For example, if the energy sensitive material is sensitive to radiation in the wavelength range of about 190 nm to about 350 nm, then the selected incident radiation is outside this wavelength range.

In the process of the present invention the glancing angle is in the range of about 5 degrees to about 60 degrees from the surface of the substrate when the source of the incident radiation is a HeNe laser (wavelength of 632.8 nm). For first order diffraction, the sine of the glancing angle is the wavelength divided by the period of the structure being inspected. For a glancing angle of 60 degrees, the period of the features is 300 nm, which corresponds to 0.15 μm lines and spaces at the HeNe wavelength. For a glancing angle of 5 degrees, the period of the features is 782.2 nm which, corresponds to 0.391 μm lines and spaces at the HeNe wavelength. It is in this manner that the glancing angle prescribes the maximum and minimum feature size that can be inspected for a particular wavelength of incident radiation using the process of the present invention.

In one embodiment of the present invention, a glancing angle of about 12°, an NA of about 0.85 and a HeNe laser are used to inspect 0.2 μm lines and spaces. If the source of the incident radiation is changed to a HeCd UV source, then 0.1 μm lines and spaces can be inspected using the same glancing angle and NA. In another embodiment, a glancing angle of about 20° is used to inspect 0.25 μm lines and spaces.

Referring to FIG. 3, a beam of radiation 200 is incident on the surface 210 of an energy sensitive resist material 220. The energy sensitive resist material 220 has the latent image 230 of a pattern of lines and spaces therein. The numerical aperture of the objective is illustrated schematically as ring 240. The dashed line 250 illustrates the maximum dispersion angle for collection by the objective. In order to decrease the dispersion angle without changing the glancing angle or the NA, the wavelength of the incident radiation must be reduced. In order for the first order diffraction information 250 to be directed into the objective 240, the glancing angle 260 must be within a certain range. As previously noted the prescribed range will depend upon the wavelength of the probe beam and the numerical aperture and focal length of the objective receiving the first order diffraction information. As is apparent from FIG. 3, the first order diffraction information is directed into the numerical aperture 240 of the objective. The information is then conveyed to a device such as a video camera in order to generate a resolved image of the latent image in the resist material.

The particular wavelength of the incident radiation is selected based upon the sensitivity of the energy sensitive resist material containing the latent image and the numerical aperture of the objective. The wavelength of the incident radiation must no destroy or alter the latent image under inspection. Therefore the wavelength of the incident radiation is selected so that incident radiation will not induce a change in the energy sensitive material that will either destroy or alter the latent image therein. The wavelength is also selected to ensure that the first order diffraction intensity is collected by the objective. Since the glancing angle is a function of the wavelength of the incident radiation, if the wavelength is too large, then the glancing angle is also too large. For example, if the energy sensitive material is sensitive to deep ultraviolet radiation (i.e. about 190 nm to about 300 nm) then laser illumination sources such as HeNe and HeCd (which provide incident radiation in the wavelength range of 632.8 nm to about 325 nm) are contemplated as suitable.

**Example 1**

In order to perform the diffractive intensity quality technique of the present invention, a semiconductor wafer was coated with a layer of an energy sensitive material. Specifically, an ARCH II photoresist (obtained from the Olin Microelectronics Group of East Providence, Rhode Island) was applied onto silicon wafers and spun into films thereon. The thickness of the resulting films was about 630 nm. The photoresist films were patternwise exposed to patterned radiation with a wavelength of 248 nm. The exposure tool was a GCS XLS deep-ultraviolet excimer laser-based stepper, which was obtained from GCA. The radiation was patterned by transmission through a mask having a pattern of 0.25 μm lines and spaces (0.5 μm period). The mask had multiple arrays of line and space patterns, one in which the lines and spaces were in the horizontal direction and one in which the lines and spaces were in the vertical direction, in the exposure field.

The mask was used to introduce a number of latent images into a layer of energy sensitive resist material formed on a silicon wafer. After a latent image was introduced, the wafer was stepped to the next position and a subsequent latent image was introduced. The stepper micro-stepped the wafer in a serpentine fashion, thereby introducing a series of latent images in that serpentine pattern in the energy sensitive material.. At each step, a variable of the exposure apparatus or tool (e.g. focus, dose, etc.) was changed to produce data that was articulable into a three-dimensional array. The array contains X-Y grating locations as diffraction intensities (Z) at each location. The location at which the image exhibits maximum intensity is the point at which the best focus was obtained.

The apparatus used to inspect the latent image was a microscope fitted with a micropositioning X-Y stage with controller. The latent images were inspected by placing the wafer on which they were formed onto the micropositioning stage. Computer control of the micropositioning stage moves the wafer within the capturing range of the microscope objective. The objective used to obtain the first order diffraction information reflected from the wafer had a 0.85 NA and a 12 mm long focal distance. The objective was optically coupled to a video camera.

A helium neon laser beam with a wavelength of 632 nm and mounted on the microscope was split into two beams using a beam splitter. Both beams were directed onto the surface of the wafer at a 20° glancing angle. One beam was oriented to illuminate the vertical gratings and the other beam was rotated 90° from the first to illuminate the horizontal gratings.

An infrared laser auto focusing system was used to keep the image in focus and correct for changes in the distance between the objective and the wafer plane. The objective was placed physically in front of a photomultiplier tube. When the wafer was stepped into the desired position, the probe beam was directed onto the latent images in the layer of energy sensitive material on the wafer surface. Angular dispersion intensity was created by the latent image. The objective and the photomultiplier tube were in the optical path of the higher order diffraction (i.e. first and above) from the grating. The objective therefore was used to allow only the intensities of the higher order diffractions to collect in the photomultiplier tube. The information collected by the photomultiplier tube was converted from analog to digital representation.

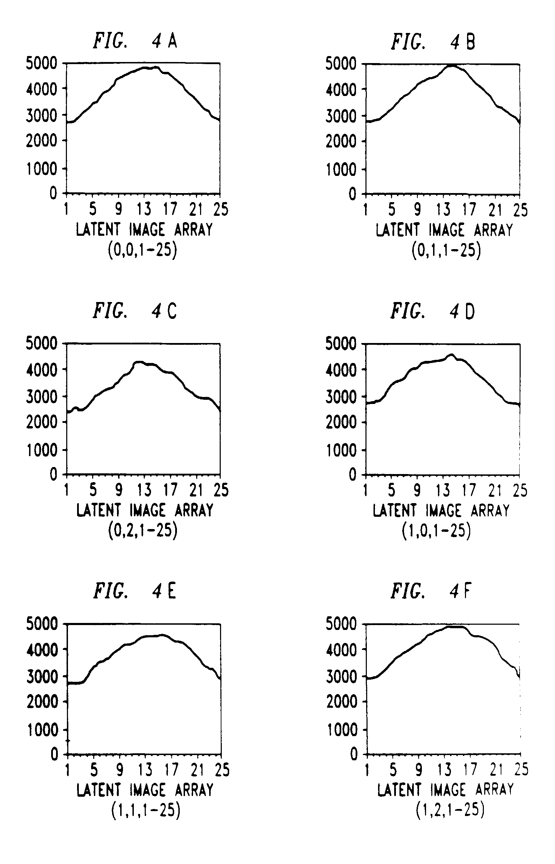

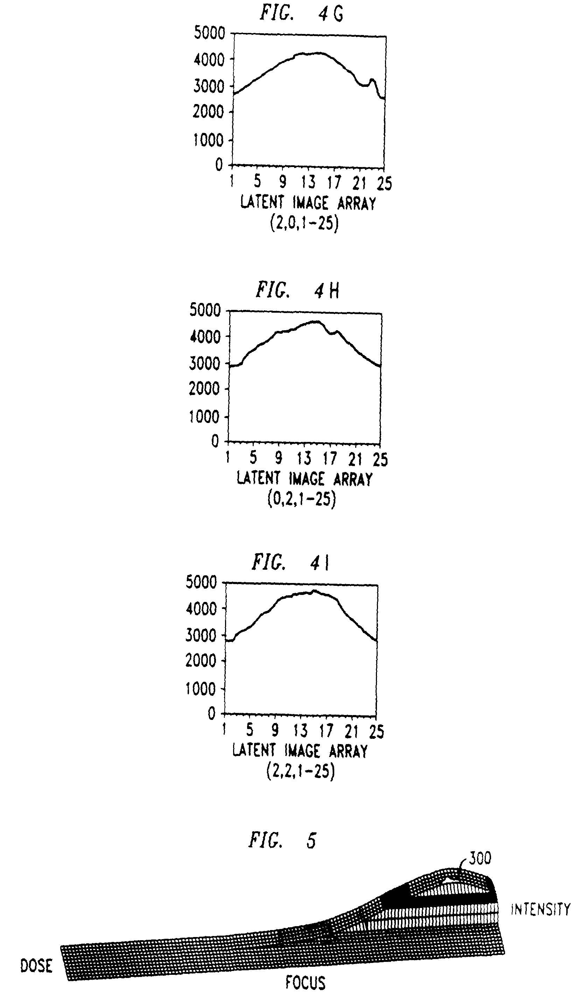

The first order diffraction information obtained in the above-described manner was used to adjust the focus of the stepper. As previously noted, a mask with both horizontal and vertical grating patterns was used to pattern radiation. Multiple latent images of these patterns were introduced into the energy sensitive material. The stepper focus and the position of the energy sensitive material were adjusted for each image. First order diffraction information for each latent image was obtained by directing the HeNe laser beam at the latent image in the previously described manner. This information provided a relationship between the focus and the intensity of the light reflected from the surface of the wafer. The relationships obtained at each focus are illustrated in FIGs. 4A-4I. Each graph represents a map of the intensity of the series of 25 exposures. The optimum focus in each of FIGs. 4A-4I is indicated by the maximum intensity. By observing the maximum intensity in each of FIGs. 4A-4I, an average optimum focus was readily determined.

### Example 2

The process of the present invention was used to control the exposure patterns of a SCALPEL lithography tool. A layer of a chemically amplified deep UV energy sensitive resist material was formed on a silicon substrate. The inspection pattern was a series of 180 nm lines and spaces. Some of the inspection patterns were oriented in a first direction and the remaining inspection patterns were oriented in a second direction orthogonal to the first direction. For example, if a first series of lines and spaces were oriented so that the lines and spaces were parallel to an imaginary line, the second series is oriented orthogonal to that imaginary line.

A SCALPEL mask was used to introduce an image of the series of 180 nm lines and spaces in an energy sensitive material. An ARCH I Photoresist (obtained from the Olin Microelectronics Group of East Providence, Rhode Island) was applied onto silicon wafers and spun into films thereon. was used to introduce a number of such latent images into the layer of energy sensitive resist material. The exposure field size was $250\,\mu m$ by $250\,\mu m$. After a latent image was introduced using a first focus and a first dose, the wafer was stepped to the next position. The stepper moved the wafer along the x-axis in the stepper range of motion to position the wafer for the next exposure. In the subsequent exposure in the x-direction, the focus remained fixed and the dose was changed from exposure to exposure (i.e. $7\,\mu C/cm^2$ to $15\,\mu C/cm^2$ in $0.2\,\mu C/cm^2$ increments). The focus remained fixed for all seventy exposures in a given row.

The stepper then positioned the wafer back at its origin. The stepper then moved the wafer along the y-axis of the stepper's range of motion. A second row of latent images was then created. In the second row, each latent image was created using a fixed, second focus. The dose was varied from exposure to exposure in the second row in the same manner that it was varied from exposure to exposure in the first row. The process was repeated to create twenty rows of latent images. Each row had seventy exposures. The latent images in a given row were generated using a fixed focus, but the focus was varied (i.e. a focus varied from 0 to 400 µm in ????? µm increments) from row to row. Consequently, 1400 exposure fields were generated, wherein each field had a unique dose and focus.

A three-dimensional dose/focus matrix was created, where the z-axis was the sensitivity or diffraction intensity for a particular value of dose and focus. The three-dimensional dose/focus matrix is illustrated in FIG. 5. The apparatus used to inspect the latent image for diffraction intensity was the same as the apparatus described in Example 1. The maximum Z value illustrated as 300 in FIG. 5 corresponds to the best combination of focus and dose.

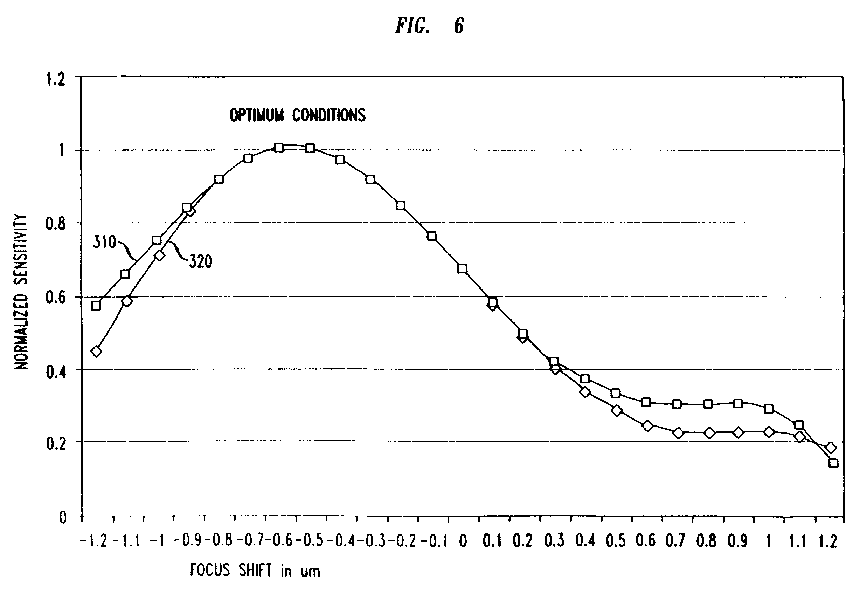

FIG. 6 illustrates the relationship between the focus of each latent image and the image intensity for both the "horizontal" and "vertical" features. The image intensity as a function of focus for the vertical features is illustrated as line 310. The image intensity as a function of focus for the horizontal features is illustrated as 320. The best focus is indicated by the point on the curves 310 and 320 that corresponds to the peak intensity.

### Claims

**1.** A lithographic process for fabricating a device comprising:

forming a layer of energy-sensitive resist material onto a substrate;

exposing at least a portion of the energy sensitive resist to patterned radiation, thereby introducing a latent image of the pattern into the energy-sensitive resist material wherein the latent image of the pattern produces a diffraction intensity when radiation is incident thereon;

inspecting the latent image by directing a beam of radiation onto the latent image at a glancing angle with the layer of energy-sensitive material selected to direct at least first order diffraction information in the light reflected from the substrate into an objective with a numerical aperture without introducing zero order diffraction information;

correlating the first order diffraction information for the latent image to a parameter used to introduce the latent image into the energy sensitive resist material wherein the parameter is selected from the group consisting of lithographic process parameters and lithographic tool parameters; and

controlling the lithographic process parameter based upon the correlation.

2. The process of the claim 1 wherein the wavelength of the beam of radiation is about 632.8 nm to about 325 nm.

3. The process of claim 2 wherein the glancing angle is about five degrees to about sixty degrees from the surface of the substrate.

4. The process of claim 1 wherein the first order diffraction information is correlated to the lithographic process parameter by creating a plurality of latent images in the energy sensitive material wherein at least one lithographic parameter is varied when creating the plurality of latent images and observing a relationship between the first order diffraction information and the varied lithographic parameter.

5. The process of claim 1 wherein the lithographic process parameter is selected from the group consisting of lens aberrations, machine focus, exposure dose, source coherence, local leveling, field uniformity, depth of focus, exposure column tilt, exposure tool resolution, focus offset, and post exposure bake.

6. The process of claim 1 wherein the parameter is controlled by selecting a value of first order diffraction information that indicates an acceptable latent image and using the parameter that is correlated with the selected value of first order diffraction information in a lithographic process for device fabrication.

7. The process of claim 5 wherein the lens aberrations are selected from the group consisting of lens astigmatism, field curvature, spherical aberrations and coma.

8. The process of claim 1 wherein the lithographic tool parameter is an apparatus selected from the group consisting of lithographic tools, stages for moving the substrate in the lithographic tool, and chucks for holding the substrate in the lithographic tool.

9. The process of claim 1 wherein the lithographic process parameter is an environment in which the substrate with the energy sensitive resist material is located when the latent image is introduced into the energy sensitive material.

FIG. 1

FIG. 2

FIG. 3

FIG. 4 A

LATENT IMAGE ARRAY
(0,0,1-25)

FIG. 4 B

LATENT IMAGE ARRAY
(0,1,1-25)

FIG. 4 C

LATENT IMAGE ARRAY
(0,2,1-25)

FIG. 4 D

LATENT IMAGE ARRAY
(1,0,1-25)

FIG. 4 E

LATENT IMAGE ARRAY
(1,1,1-25)

FIG. 4 F

LATENT IMAGE ARRAY
(1,2,1-25)

FIG. 4 G

LATENT IMAGE ARRAY
(2,0,1-25)

FIG. 4 H

LATENT IMAGE ARRAY
(0,2,1-25)

FIG. 4 I

LATENT IMAGE ARRAY
(2,2,1-25)

FIG. 5

DOSE

FOCUS

INTENSITY

300

EP 0 985 977 A1

## FIG. 6

European Patent
Office

**EUROPEAN SEARCH REPORT**

Application Number

EP 99 30 6919

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | HICKMAN K C ET AL: "USE OF DIFFRACTED LIGHT FROM LATENT IMAGES TO IMPROVE LITHOGRAPHY CONTROL" JOURNAL OF VACUUM SCIENCE AND TECHNOLOGY: PART B, vol. 10, no. 5, 1 September 1992 (1992-09-01), pages 2259-2266, XP000322772 ISSN: 0734-211X * the whole document * | 1-9 | G03F7/20 |
| X | SHOAIB ZAIDI ET AL: "METROLOGY SENSORS FOR ADVANCED RESISTS" PROCEEDINGS OF THE SPIE, vol. 2196, 28 February 1994 (1994-02-28), pages 341-351, XP000562171 * figure 2 * | 1-9 | |
| X | EP 0 469 765 A (AMERICAN TELEPHONE & TELEGRAPH) 5 February 1992 (1992-02-05) * the whole document * | 1-9 | |
| X | US 5 556 726 A (YUAN CHI-MIN) 17 September 1996 (1996-09-17) * column 2, line 15 - line 32 * | 1 | TECHNICAL FIELDS SEARCHED (Int.Cl.7) G03F |
| X | US 5 673 101 A (TENNER MANFRED G ET AL) 30 September 1997 (1997-09-30) * column 4, line 1-13 * * column 6, line 3-8 * * column 5, line 57-64 * | 1-9 | |
| A | STURTEVANT J L ET AL: "POST-EXPOSURE BAKE AS A PROCESS-CONTROL PARAMETER FOR CHEMICALLY- PHOTORESIST" PROCEEDINGS OF THE SPIE, vol. 1926, 2 March 1993 (1993-03-02), pages 106-114, XP000646475 | 5 | |

The present search report has been drawn up for all claims

| Place of search | Date of completion of the search | Examiner |
|---|---|---|
| THE HAGUE | 5 November 1999 | Haenisch, U |

**EP 0 985 977 A1**

**ANNEX TO THE EUROPEAN SEARCH REPORT
ON EUROPEAN PATENT APPLICATION NO.**    EP 99 30 6919

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-1999

| Patent document cited in search report | | Publication date | Patent family member(s) | | Publication date |
|---|---|---|---|---|---|
| EP 0469765 | A | 05-02-1992 | US | 5124216 A | 23-06-1992 |
|  |  |  | DE | 69110369 D | 20-07-1995 |
|  |  |  | DE | 69110369 T | 29-02-1996 |
|  |  |  | JP | 2027068 C | 26-02-1996 |
|  |  |  | JP | 4312947 A | 04-11-1992 |
|  |  |  | JP | 7040584 B | 01-05-1995 |
|  |  |  | US | 5288572 A | 22-02-1994 |
| US 5556726 | A | 17-09-1996 | US | 5476738 A | 19-12-1995 |
|  |  |  | US | 5620818 A | 15-04-1997 |
| US 5673101 | A | 30-09-1997 | DE | 69508228 D | 15-04-1999 |
|  |  |  | DE | 69508228 T | 23-09-1999 |
|  |  |  | EP | 0737330 A | 16-10-1996 |
|  |  |  | WO | 9534025 A | 14-12-1995 |
|  |  |  | JP | 9501803 T | 18-02-1997 |

EPO FORM P0459

For more details about this annex : see Official Journal of the European Patent Office, No. 12/82

14